(19) **Europäisches Patentamt**
**European Patent Office**
**Office européen des brevets**

(11) **EP 4 734 362 A1**

(12) **EUROPEAN PATENT APPLICATION**

(43) Date of publication:
**29.04.2026  Bulletin 2026/18**

(21) Application number: **24208604.9**

(22) Date of filing: **24.10.2024**

(51) International Patent Classification (IPC):
**H03F 1/02** (2006.01)     **H03F 1/22** (2006.01)
**H03F 1/30** (2006.01)     **H03F 3/195** (2006.01)
**H03F 1/32** (2006.01)

(52) Cooperative Patent Classification (CPC):
**H03F 1/223; H03F 1/0261; H03F 1/301;
H03F 1/3205; H03F 3/195;** H03F 2200/18;
H03F 2200/451

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP USA, Inc.
Austin, TX 78735 (US)**

(72) Inventors:
• **YANG, Xin
5656 AE Eindhoven (NL)**
• **DE JONG, Gerben Willem
5656 AE Eindhoven (NL)**

(74) Representative: **Hardingham, Christopher Mark
NXP Semiconductors
Intellectual Property Group
The Cattle Barn
Upper Ashfield Farm, Hoe Lane
Romsey, Hampshire SO51 9NJ (GB)**

(54) **POWER AMPLIFIER APPARATUS**

(57)     The disclosure relates to a power amplifier apparatus. A power amplifier apparatus (300) comprises: a power amplifier circuit (310) configured to receive an RF input signal at an RF input ($RF_{in}$) and to generate an RF output signal at an RF output ($RF_{out}$); an adaptive bias circuit (320) comprising a biasing transistor (M3), the biasing transistor (M3) having a common terminal coupled to the RF input ($RF_{in}$) and to a tail current source ($I_{bias}$), and the biasing transistor (M3) further having an input terminal coupled to a DC bias voltage source ($dc_{bias}$); and a rectification booster (330) comprising a current mirror device, wherein a first side of the current mirror device is coupled to an output terminal of the biasing transistor (M3) and wherein a second side of the current mirror device is coupled to the RF input ($RF_{in}$).

Fig. 3

EP 4 734 362 A1

**Description**

Field

The disclosure relates to a power amplification apparatus.

Background

Power amplifiers are devices that are used in a wide array of electronics applications, including radar, telecommunications and signals processing. Generally, a power amplifier can be understood to receive an input signal and generate an amplified output signal.

In order to improve the linearity of the power amplifier's response, an adaptive bias circuit may be provided at the input of the power amplifier. The adaptive bias circuit is able to provide a bias voltage to the input of the power amplifier, the bias voltage being dynamically varied in response to varying power of the input signal.

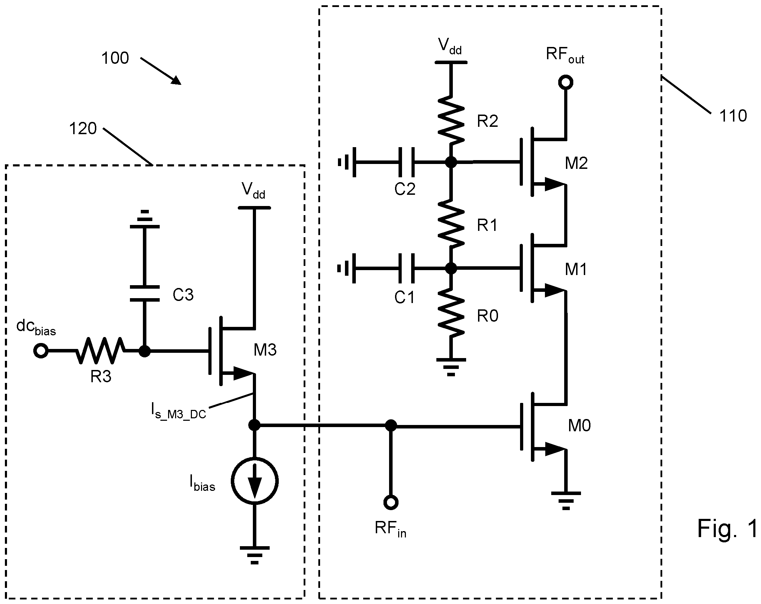

Conventional adaptive bias circuits (like those shown in Figure 1, for example) pose some limitations. Because the adaptive bias circuit must necessarily adaptively charge and discharge the inherent input capacitance of the power amplifier, the bias voltage variation may be not fast enough to track the envelope of input signal. This can result in "memory effect" problems, whereby the variation of the bias voltage lags behind the variation in the input signal, thereby degrading the performance of the power amplifier due to ineffective linearisation.

Thus, the implementation of power amplifiers comprising adaptive bias circuits - particularly in high frequency applications, such as 5G or millimetre-wave (mmW) technologies - has proven challenging.

Summary

According to a first aspect there is provided a power amplifier apparatus. The power amplifier apparatus comprises: a power amplifier circuit configured to receive an RF input signal at an RF input and to generate an RF output signal at an RF output; an adaptive bias circuit comprising a biasing transistor, the biasing transistor having a common terminal coupled to the RF input and to a tail current source, the biasing transistor further having an input terminal coupled to a DC bias voltage source; and a rectification booster comprising a current mirror device, wherein a first side of the current mirror device is coupled to an output terminal of the biasing transistor and wherein a second side of the current mirror device is coupled to the RF input.

The biasing transistor may be referred to as a rectification or rectifying transistor; the adaptive bias circuit is able to rectify the RF input signal, resulting in bias voltage variation provided to the power amplifier circuit (discussed further below). The rectification booster can be used to increase a base-band current that is provided by the adaptive bias circuit to the power amplifier circuit, thereby providing for more powerful charging of a transistor in the power amplifier circuit that receives the RF input signal. Thus, the apparatus of the present disclosure may advantageously have reduced memory effect and be capable of providing wider modulation bandwidth. Said power amplifier apparatus may be used for 5G telecommunications or automotive mmW radar applications, for example.

In the present disclosure, transistors are generally considered to be field effect transistors (FETs), such that the common terminal, input terminal and output terminal are a source connection, a gate connection and a drain connection, respectively. It will be understood that other devices may be used instead of FETs. For example, the apparatus may comprise bipolar junction transistors (BJTs) having an emitter connection, a base connection and a collector connection.

The current mirror device may comprise a first pair of transistors, wherein: each transistor of the first pair of transistors comprises an input terminal coupled to one another; a first transistor of the first pair of transistors comprises an output terminal coupled to the output terminal of the biasing transistor; a second transistor of the first pair of the transistors comprises an output terminal coupled to the RF input; and the input terminals of each transistor of the first pair of transistors are coupled to the output terminal of the first transistor of the first pair of transistors.

The first transistor and the second transistor may form the first and second side of the current mirror device respectively. The proprieties of the first and second transistors may be chosen so that the current mirror device sufficiently amplifies/boosts an input current, thereby automatically generating an adequately boosted bias current for providing to the power amplifier circuit.

The current mirror device may comprise a second pair of transistors. Each transistor of the second pair of transistors may comprise an input terminal coupled to one another. The input terminals of each transistor of the second pair of transistors may be coupled to the output terminal of the first transistor of the second pair of transistors. The first and second pair of transistors may be stacked with respect to the first pair of transistors, such that an output terminal of the first transistor of the second pair of transistors is coupled to a common terminal of the first transistor of the first pair of transistors and an output terminal of the second transistor of the second pair of transistors is coupled to a common terminal of the second transistor of the first pair of transistors.

The current mirror device may comprise further pairs of transistors, the further pairs of transistors being stacked with respect to the second pair of transistors.

By using stacked pairs of transistors in the current mirror device of the rectification booster (e.g., two or more pairs of transistors), the rectification booster may advantageously be able to handle greater supply voltages, as the supply voltage is distributed over more transistors.

A further transistor may be coupled to the first pair of transistors, the further transistor having a common terminal coupled to the output terminal of the second transistor of the first pair of transistors and the further transistor further having an output terminal and an input terminal coupled to the RF input.

The further transistor may further help to distribute the voltage drop from a supply voltage applied to the current mirror device. The further transistor can reduce the drain-to-gate voltage drop across the second transistor of the first pair of transistors. This may increase the safe operating area (SOA) and/or improve the reliability of the rectification booster.

The width-to-length (W/L) aspect ratio of a second transistor of a main pair of transistors of the current mirror device may be unequal to the W/L aspect ratio of a first transistor of the main pair of transistors.

Where the current mirror device comprises only a first pair of transistors, the main pair of transistors will be the first pair of transistors. When there are N pairs of transistors arranged in a stacked formation, as discussed above, the $N^{th}$ pair may be the main pair (i.e., the pair of transistors that perform the current mirroring, according to a certain ratio).

The W/L ratio can influence the current mirror ratio of the current mirror device, i.e., the magnitude by which the current is amplified across the current mirror. The W/L ratio of the second transistor may be greater than the W/L ratio of the first transistor. The W/L ratio of the second transistor may be double, or at least double, the W/L ratio of the first transistor, for example. By having a W/L ratio of the second transistor at least double that of the first transistor in the current mirror device, the current mirror ratio may be sufficient such that the rectification booster provides an adequate boost to the bias current.

Where the current mirror device comprises a plurality of pairs of transistors arranged in a stack, the ratio of W/L ratios of the second pair of transistors (and/or third pair, etc.) may be unequal. Although referred to as the 'first' pair of transistors, it will be understood that, when the current mirror comprises two pairs of transistors in a stacked arrangement, the 'second' pair will be the main transistor pair that primarily determines the current mirror ratio, for example. Regardless of how many pairs of transistors are provided in the current mirror device, the ratio of W/L ratios of the main pair of transistors may be appropriately configured to provide the desired current mirror ratio. The other pairs of transistors may have the same W/L ratio.

The first side and the second side of the current mirror device may be coupled to a common supply voltage.

The rectification booster may further comprise an additional current source coupled to the output terminal of the biasing transistor.

The additional current source may advantageously reduce the current dissipation of the adaptive bias circuit. This may enable greater bias to be applied to the power amplifier circuit, thereby enabling faster switching and thus greater bandwidth.

The input terminal of the biasing transistor may be coupled to a common voltage via a capacitor and to the DC bias voltage source via a resistor.

Providing a capacitor coupled to the input terminal of the biasing transistor may smooth the total input capacitance variation of the power amplifier circuit and adaptive bias circuit as the power of the RF input signal is varied. The capacitor can control the contribution of the gate-to-source capacitance of the biasing transistor during rectification operation, which may in turn compensate the $C_{gs\_M0}$ of a transistor of the power amplifier circuit.

The power amplifier circuit may comprise a first transistor of having an input terminal coupled to the RF input and the common terminal of the biasing transistor.

The power amplifier circuit may comprise a plurality of transistors, the plurality of transistors comprising one or more further transistors in a cascode arrangement with the first transistor. The power amplifier circuit may have a triple-stacked transistor topology. for example.

The power amplifier circuit may comprise a first transistor, a second transistor and a third transistor, wherein an output terminal of the first transistor is coupled to a common terminal of the second transistor, an output terminal of the second transistor is coupled to a common terminal of the third transistor, and an output terminal of the third transistor is coupled to the RF output.

A triple-stacked transistor topology may provide a simple power amplifier that can be easily implemented in integrated circuits (ICs) and/or where space is limited, for example. However, the present disclosure - i.e., the use of an adaptive bias circuit and a rectification booster - may equally be applied to other designs. As above, the power amplifier circuit may comprise a single transistor, rather than a cascode or stacked configuration. In this instance, the output terminal of said single transistor is coupled to the RF output.

The second transistor may comprise an input terminal coupled to a capacitor. The third transistor may comprise an input terminal coupled to another capacitor.

Providing a capacitor at each of the input terminals of the second and third transistors of the stacked power amplifier may provide for partial or "soft" decoupling of the input terminals/gates of the stacked transistors. This can provide an optimal RF voltage swing distribution over said transistors.

Each of the transistors in the power amplifier circuit may be a Complementary Metal-Oxide-Semiconductor (CMOS) transistor.

The use of CMOS transistors may provide the power amplifier apparatus with any or all of the known benefits of said transistors, e.g., lower static power consumption. However, other transistor technologies may be used in the apparatuses of the present disclosure.

The power amplifier circuit may further comprise an input impedance matching circuit configured to receive the RF input signal and an output impedance matching circuit configured to receive the RF output signal.

Providing impedance matching at the RF input and the RF output may increase the amplification provided by the power amplifier apparatus and/or may reduce signal power loss (e.g., by reducing reflectance of the RF input). Any impedance matching circuit suitable for use with power amplifiers (particularly power amplifiers operating with 5G or millimetre-wave signals) may be used in the apparatus of the present disclosure.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic diagram of a known power amplifier apparatus;

Figure 2 is a graph illustrating the linearisation performance of the power amplifier apparatus of Figure 1;

Figure 3 is a schematic diagram of an example of a power amplifier apparatus according to the present disclosure;

Figure 4 is a graph illustrating the linearisation performance of the power amplifier apparatus of Figure 3 with respect to tone spacing frequency;

Figure 5 is a graph illustrating the linearisation performance of the power amplifier apparatus of Figure 3 with respect to capacitance at a gate of a biasing transistor;

Figure 6 is a graph showing the dynamic response of a power amplifier apparatus;

Figure 7 is a schematic diagram of an alternative example of a power amplifier apparatus according to the present disclosure; and

Figure 8 is a schematic diagram of a further alternative example of a power amplifier apparatus according to the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

Detailed description of embodiments

Figure 1 shows a power amplifier apparatus 100 comprising a power amplifier circuit 110 and an adaptive bias circuit 120. The power amplifier apparatus 100 is of a known design, wherein the adaptive bias circuit may be used to improve the linearity of the power amplifier apparatus 100. Linearity may be characterised using the output third-order intercept point (OIP3) under a two-tone test, for example (described further in the examples below).

The power amplifier circuit 110 is of a triple-stacked power amplifier design. The power amplifier circuit 110 comprises three stacked transistors M0, M1, M2. The drain of a first transistor M0 is coupled to the source of a second transistor M1 and the drain of the second transistor M1 is coupled to the source of a third transistor M2. Throughout the present disclosure, each of the transistors can be understood to have a drain connection, gate connection and/or source connection, to which other components can be coupled (e.g., a physical pin on the transistor). However, for brevity, the components are described as being coupled to the drain, gate and/or source of the transistors.

The gate of second transistor M1 is coupled to a first capacitor C1, and the gate of the third transistor M2 is coupled to a second capacitor C2. The first and second capacitors C1, C2 are provided between the respective transistor gates and ground. A plurality of resistors R0, R1, R2 are provided in series between a supply voltage $V_{dd}$ and ground. A first resistor R0 is coupled to ground and to a junction located between the first capacitor C1 and the gate of the second transistor M1; A second resistor R1 is coupled to the junction located between the first capacitor C1 and the gate of the second transistor M1 and a junction between the second capacitor C2 and the gate of the third transistor M2; and a third resistor is coupled to a junction located between the second capacitor C2 and the gate of the third transistor M2 and the supply voltage $V_{dd}$.

The gate of the first transistor M0 of the power amplifier circuit 110 is coupled to an RF input $RF_{in}$ (i.e., an input node/terminal which receives an RF input signal) and the drain of the third transistor M2 of the power amplifier circuit 110 is coupled to an RF output or load (i.e., an output node/terminal which outputs an RF output signal). The source of the first transistor M0 of the power amplifier circuit 110 may be coupled to ground.

The adaptive bias circuit 120 comprises a biasing transistor M3. The source of the biasing transistor M3 is coupled to the RF input $RF_{in}$ and to the gate of the first transistor M0 of the power amplifier circuit 110; the drain of the biasing transistor M3 is coupled to supply voltage $V_{dd}$; and the gate of the biasing transistor M3 is coupled to a direct current (DC) voltage source $dc_{bias}$ via a resistor R3. The $dc_{bias}$ voltage source can be any suitable voltage source. The resistor R3 is arranged in series between the $dc_{bias}$ voltage source and the gate of the biasing transistor M3. The resistor R3 may not serve a purpose in DC operations since the gate of biasing transistor M3 may be an open circuit. R3 may provide an RF-open (or high-Ohmic termination) during the RF rectification operation. However, the resistance of R3 is not too large; R3 should provide an RF-open and baseband-short. The resistance of R3 may be 5 to 50 k$\Omega$, for example. For the rectification provided by the present disclosure, it may be assumed that the magnitude of the base-band impedance of gate-to-source capacitance ($C_{gs\_M3}$) is much larger than that of R3. Therefore, base-band voltage variations at the gate of the biasing transistor M can be regarded as negligible with respect to the base-band voltage variations at the source of basing transistor M3. The gate of the biasing transistor M3 is also coupled to a common voltage (e.g., ground) via a capacitor C3. A further tail current source $I_{bias}$ is also coupled to the source of the biasing transistor M3.

As the power of the RF input signal provided to the power amplifier circuit 110 is increased, the biasing transistor M3 acts to rectify an RF component of the gate-source voltage $V_{gs}$ across the biasing transistor M3 by increasing the DC component of bias current $I_{s\_M3\_DC}$ at the source of the biasing transistor M3. The DC source bias current $I_{s\_M3\_DC}$ of the biasing transistor M3 is fixed by the tail current source $I_{bias}$, and thus the DC component of the biasing transistor M3 gate-source voltage $V_{gs\_M3\_DC}$ decreases, thereby keeping the bias current constant as the power of the RF input signal increases.

Because the DC voltage of the biasing transistor M3 gate is constant and the gate-source voltage $V_{gs\_M3}$ of the biasing transistor M3 decreases, as the power of the RF input signal increases and the input power increases, the DC component of the gate-source voltage $V_{gs\_M0\_DC}$ of the first transistor M0 of the power amplifier circuit 110 also increases. Accordingly, the DC bias current of the first transistor M0 of the power amplifier circuit 110 increases. This increase may increase the RF gain of the first transistor M0, which will at least partially compensate for the natural/original gain compression associated with the input power increasing. Thus, the adaptive bias circuit can enable improved linearity in the power amplifier's response.

Impedance matching circuits (not shown) may be provided at the RF input $RF_{in}$ and the RF output $RF_{out}$ of the power amplifier circuit (110), such that the RF input signal and the RF output signal have matched impedance. The impedance matching circuits may be L-type, T-type or pi-type impedance matching circuits, for example.

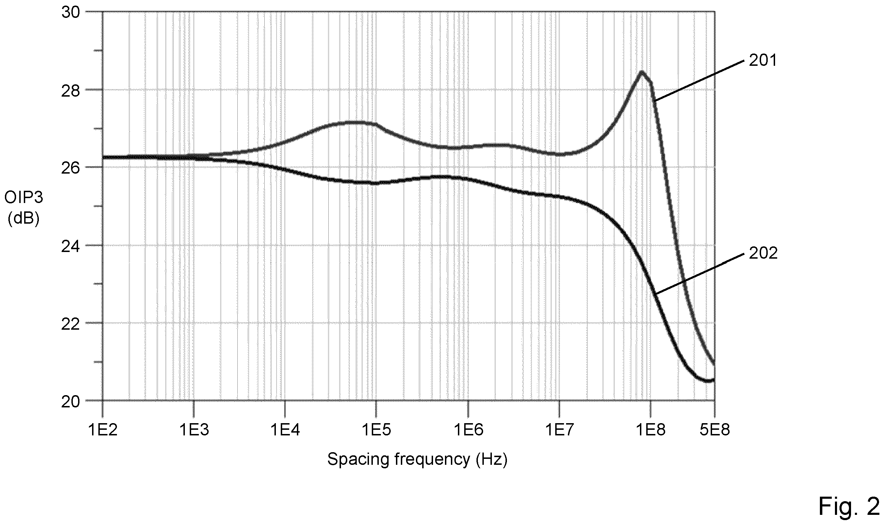

Figure 2 is a graph of the OIP3 performance of the power amplifier apparatus 100 of Figure 1 (i.e., comprising an adaptive bias circuit 120), discussed further below. The graph shows the OIP3 characteristics of the power amplifier against tone spacing frequency $F_{space}$. The power amplifier used was a 28 GHz power amplifier (i.e., having a centre frequency $F_{centre}$ of 28 GHz) with an $OP_{1dB}$ compression parameter of approximately 19 dBm.

The graph of Figure 2 shows a two-tone simulation result with an $OIP3_{high}$ 201 and an $OIP3_{low}$ 202. The high tone frequency is equal to $F_{centre}$ + 0.5*$F_{space}$, and the low tone frequency is equal to $F_{centre}$ - 0.5*$F_{space}$. In a two-tone test, the targeted $F_{space}$ frequency (e.g., 200 MHz) may be referred to as the base-band signal or envelope signal. The $F_{centre}$ frequency of the signal (e.g., 28 GHz) may be referred to as the RF signal or carrier signal.

Figure 2 shows that there is a significant drop in OIP3 for tone spacing frequencies above 100 MHz. The $OIP3_{high}$ 201 drops from ~ 27 dB to 24 dB as the tone spacing frequency increases to 200 MHz, while the $OIP3_{low}$ 202 drops from ~ 26 dB to 21 dB as the tone spacing frequency increases to 200 MHz.

For certain applications, for example 5G or mmW technologies, a modulation bandwidth of at least 200 MHz will be required. Therefore, as discussed above, conventional adaptive bias circuits used in power amplifiers are unsuitable for high-bandwidth applications. The adaptive bias circuit is unable to react fast enough, thereby resulting in memory effect in the RF output signal.

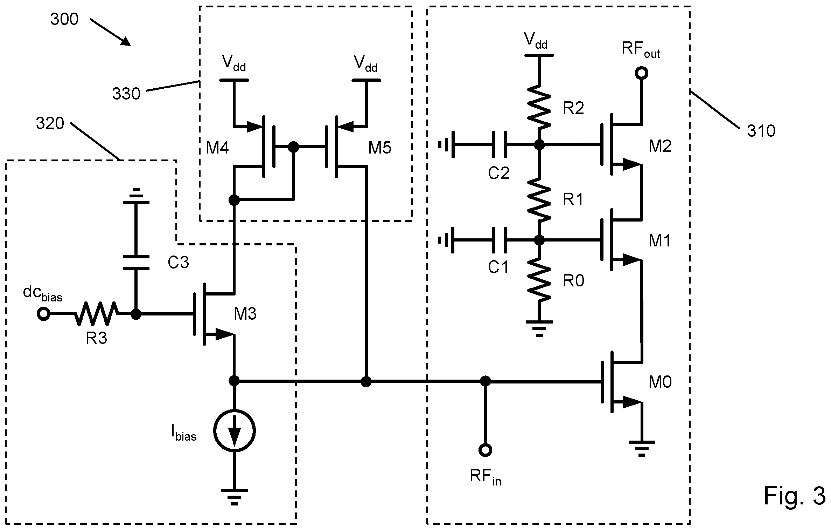

Figure 3 shows a schematic diagram of a power amplifier apparatus 300 according to the present disclosure. The power amplifier apparatus 300 comprises a power amplifier circuit 310 and an adaptive bias circuit 320.

These may have the same construction and function as the power amplifier circuit 110 and adaptive bias circuit 120 and are labelled accordingly.

The power amplifier apparatus 300 further comprises a rectification booster 330. The rectification booster 330 generally comprises a current mirror device. The current mirror device may be any suitable current mirror that functions to receive a current at an input terminal (first side) of the current mirror and produce a (scaled) copy of the received current at an output terminal (second side) of the current mirror. The current mirror device may have a mirror ratio $M$, such that the output current is amplified by 1:M relative to the input current. The current mirror device may be a Wilson current mirror or a Widlar current mirror, for example.

In the example of Figure 3, the current mirror device of the rectification booster 330 comprises a pair of transistors M4, M5, the transistors providing the first side and second side of the current mirror respectively. The drain of the first transistor M4 of the pair of transistors is coupled to the drain of the biasing transistor M3 of the adaptive bias circuit 320. The drain of the second transistor M5 of the pair is coupled to the gate of the first transistor M0 of the power amplifier circuit 310, along with the RF input $RF_{in}$. The gates of the pair of transistors M4, M5 are coupled to one another and also to the drain of the first transistor M4 of the pair. The sources of the pair of transistors M4, M5 are each coupled to a supply voltage, which may be a common supply voltage $V_{dd}$.

The second transistor M5 of the pair may have a width-to-length ratio that is unequal to that of the first transistor M4. That is, the mirror ratio $M$ of the rectification booster 330 is > 0. For example, the W/L ratio of M5 may be greater than (e.g., double) that of M4. As a result, the rectification booster 330 functions to boost the rectified base-band current of the biasing transistor M3.

As discussed above, when a modulated RF signal is provided as an RF input signal to the power amplifier circuit 310, the biasing transistor M3 generates a rectified base-band current (with an envelope that matches the modulation of the RF carrier signal) to charge and discharge the first transistor M0 of the power amplifier circuit 310. Because the first transistor M4 of the rectification booster 330 is coupled to biasing transistor M3 (the first side of the current mirror), the rectification booster 330 generates an amplified copy of the base-band current at the second transistor M5 (the second side of the current mirror). This amplified base-band current is provided to the gate of the first power-amplifier transistor M0.

Therefore, the rectification provided by the biasing transistor M3 is increased via the rectification booster 330 compared to the adaptive bias circuit alone; a greater base-band current is generated and provided to the power amplifier for the same RF voltage change. Due to the additional current provided by the current mirror and tail current $I_{bias}$, the combination of the rectification booster 330 and the adaptive bias circuit 320 is able to more powerfully charge/discharge the M0 transistor input capacitance. The current may be increased by a factor of three, for example. Thus, the biasing may be varied at greater frequency, thereby enabling the power amplifier apparatus 300 to operate with wider modulation bandwidth.

In Figure 3, the adaptive bias circuit 320 and the rectification booster 330 are applied to a power amplifier circuit 310 with a triple-stacked transistor topology, in order to provide comparison with the apparatus of Figure 1. The adaptive bias circuit 320 and the rectification booster 330 of the present disclosure may be applied to any suitable topology, for example single common-source or cascode configured power amplifiers. Likewise, the transistors discussed herein are presented as CMOS transistors. But any suitable transistor may be used, for example SiGe Heterojunction Bipolar Transistors (HBTs) or InP High-electron-mobility Transistors (HEMTs). The skilled person will understand any necessary modifications required for using these transistor technologies in the apparatuses of the present disclosure.

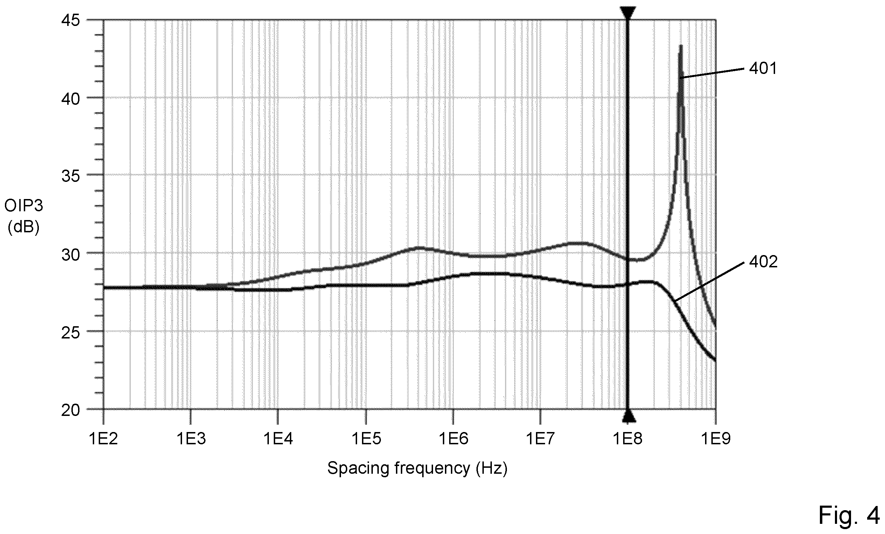

Figure 4 is a graph of the OIP3 performance of the power amplifier apparatus 300 of Figure 3. The same two-tone simulation of $OIP3_{high}$ 401 and an $OIP3_{low}$ 402 was used for Figure 4 as was used for Figure 2; the RF signal is 28 GHz.

When compared to Figure 2, the graph of Figure 4 shows that the inclusion of the rectification booster 330 significantly improves the OIP3 bandwidth of the power amplifier apparatus 300. Without the rectification booster, Figure 2 showed that OIP3 dropped by approximately 5 dB as the tone spacing was increased to 200 MHz. Meanwhile, the OIP3 of the power amplifier apparatus 300 comprising the rectification booster 330 is almost constant up to 200 MHz, both for the $OIP3_{high}$ 401 and $OIP3_{low}$ 402. Thus, the power amplifier apparatus 300 of Figure 3 may have improved performance in high frequency applications and/or exhibit less memory effect.

The rectification booster 330 may advantageously increase the transconductance compared to simply scaling up the biasing transistor M3 and/or tail current $I_{bias}$. The capacitor C3 of the adaptive bias circuit 120, 320 (shown in Figures 1 and 3) is a soft-decoupling capacitor that determines the contribution of variation of the gate-to-source capacitance $C_{gs}$ in the transistors.

The rectification provided via biasing transistor M3 also compensates the $C_{gs}$ variation of transistor M0 at the power amplifier circuit as the power of $RF_{in}$ changes. The simplified total input capacitance at the RF input $C_{RFin}$ is given by:

$$C_{RFin} = C_{gs_{M0}} + \cfrac{1}{\cfrac{1}{C_{gs_{M3}}} + \cfrac{1}{C_{C3}}} \qquad (1)$$

where $C_{gs\_M0}$ and $C_{gs\_M3}$ are the gate-to-source capacitances of M0 and M3 respectively, and $C_{C3}$ is the capacitance of capacitor C3. When the input power of $RF_{in}$ increases, $V_{gs\_M0}$ increases and $C_{gs\_M0}$ is also increased. Since $V_{gs\_M3}$ is decreased to keep the DC component of a drain current at biasing transistor M3 constant, $C_{gs\_M3}$ is decreased and compensates the variation of $C_{gs\_M0}$. The capacitance of C3 is thus applied to adjust the contribution of variation of $C_{gs\_M3}$, such as to make $C_{RFin}$ constant.

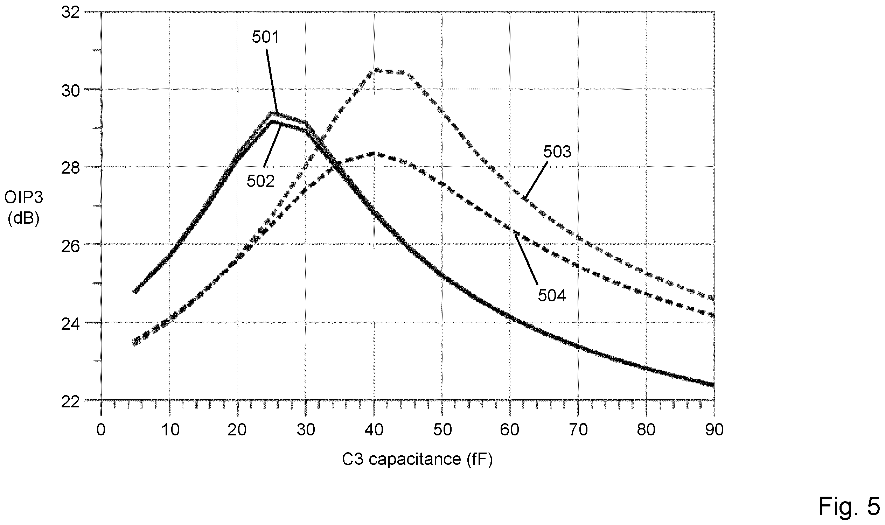

A constant $C_{RFin}$ suppresses the generation of the third-order intermodulation product (IM3). Figure 5 is a graph of the OIP3 performance vs C3 capacitance of the power amplifier apparatus 300 of Figure 3, again using an RF signal $F_{centre}$ of 28 GHz. The same two-tone simulation was performed (i.e., $F_{centre} \pm 0.5*F_{space}$) for tone spacings of 1 kHz and 100 MHz. The graph shows that - when considering the $OIP3_{high}$ 501 and $OIP3_{low}$ 502 at 1 KHz (solid lines), and the $OIP3_{high}$ 503 and $OIP3_{low}$ 504 at 100 MHz (dashed lines) - the optimum C3 capacitance is approximately 35 fF.

Referring to the known power amplifier apparatus 100 of Figure 1, and following the conclusion of equation 1 above, if biasing transistor M3 and/or $I_{bias}$ are increased to increase the modulation bandwidth by increasing the transconductance, the capacitance $C_{C3}$ will need to be decreased to compensate the total input capacitance. However, decreasing $C_{C3}$ reduces the rectification operation of the adaptive biasing circuit, thereby degrading the linearisation.

The biasing transistor M3 can at least partially rectify the RF component of the RF input signal to generate an RF-amplitude-dependent bias voltage for the first transistor M0 of the power amplifier circuit 310. This can improve the linearity of the amplification. The RF-amplitude-dependent bias voltage may at least partially counteract the natural gain compression of the first transistor M0, which would otherwise result in a non-linear gain. Biasing transistor M3 may be biased in the subthreshold region to obtain the desired degree of rectification.

The biasing transistor gate-source voltage $V_{gs\_M3}$ can be assumed to be

$$V_{gs_{M3}} = V_{gs0} + V_{gsB} + A \cos(\omega_c t) \qquad (2)$$

where $V_{gs0}$ represents the quiescent gate-source voltage in the absence of an RF component, $V_{gsB}$ represents the deviation in gate-source bias voltage with respect to $V_{gs0}$, A represents the amplitude of the RF component which is generally a function of time, $\omega_c$ represents the radian frequency (rad/s) of the RF component (carrier) and t represents time. The radian frequency $\omega_c$ corresponds with a frequency $f_c = (\omega_c/(2\pi))$.

Using a second-order Taylor series expansion, a drain current of the biasing transistor $I_{d\_M3}$ can be approximated as

$$I_{d_{M3}} = I_{d0} + g_m \cdot V_{gsB} + g_{m2} \cdot \left(V_{gsB}^2 + \frac{1}{2}A^2\right) \qquad (3)$$

where $I_{d0}$ represents the quiescent drain current, $g_m$ represents the transconductance (A/V) of biasing transistor M3 when $V_{gs\_M3}$ equals $V_{gs0}$, and $g_{m2}$ (A/V$^2$) represents the second-order distortion coefficient of biasing transistor M3 which is responsible for the rectification effect.

For simplicity, third-order and higher-order distortion coefficients in $I_{d\_M3}$ are neglected. For the same reason, first- and higher-harmonic RF components in $I_{d\_M3}$ are neglected. This approximation is allowed since the RF components are strongly suppressed in the voltage domain by the total capacitance at the RF input $RF_{in}$. Thus, the expression (3) for $I_{d\_M3}$ only contains DC- and base-band frequency components. In the following, it is assumed that $|g_{m2} \cdot V_{gsB}^2| << |g_m \cdot V_{gsB}|$.

The RF input signal at the RF input $RF_{in}$ only partially reaches $V_{gs\_M3}$ due to a voltage division between the gate biasing transistor M3 gate-to-source capacitance $C_{gs\_M3}$ and the capacitance $C_{C3}$ of the capacitor C3. The magnitude of the RF impedance of $C_{C3}$ can be assumed to be much smaller than that of resistor R3, such that resistor R3 does not play a role in the RF voltage division.

The dynamic behavior of the power amplifier apparatus 300 can be assessed by applying a sudden change in the RF amplitude A from zero to some fixed value (i.e., a step function). Due to this, the third term in the expanded $I_{d\_M3}$ expression (3) suddenly increases and therefore the drain current $I_{d\_M3}$ of biasing transistor M3 suddenly increases. This drain current increase is boosted by a ratio of 1:M at the current mirror transistors M4/M5 and will charge the total capacitance at the RF input node $RF_{in}$, thereby causing the bias voltage at the source of biasing transistor M3 to begin to rise gradually.

Under this assessment, it is assumed that the magnitude of the base-band impedance of $C_{gs\_M3}$ is much larger than that of R3. Thus, the base-band voltage variations at the gate of biasing transistor M3 are negligible with respect to the base-band voltage variations at the source of biasing transistor M3. Therefore, the rising bias voltage at the source of M3 will cause a decreasing $V_{gsB}$ of M3. As a result, the second term in the drain current $I_{d\_M3}$ expansion will begin to drop gradually.

The above process continues until a new steady state has been reached; the initial increase of the third term is fully compensated by the final decrease of the second term. In the steady state the drain current of the biasing transistor $I_{d\_M3}$ returns to the original value $I_{d0} = I_{bias}/(1+M)$, where M is the ratio of the current mirror.

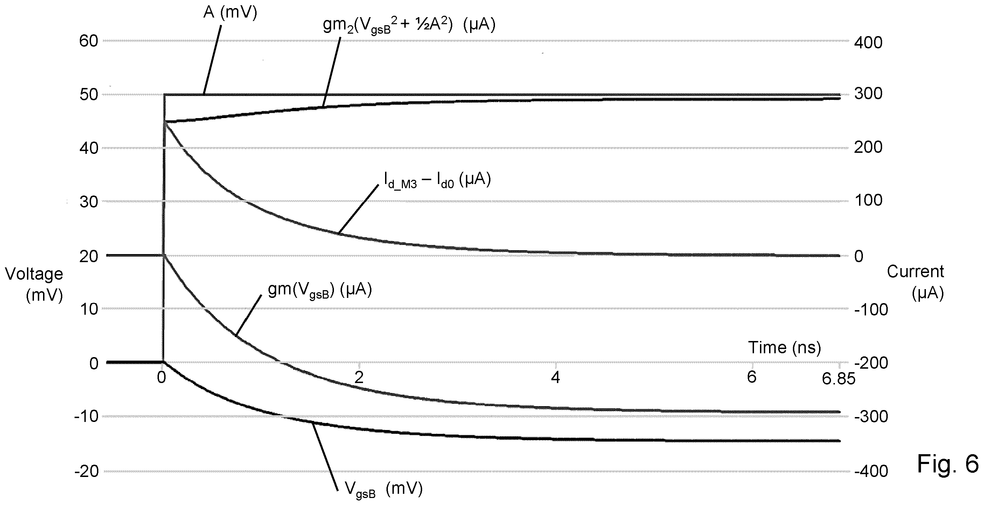

Referring to Figure 6, the graph shows the dynamic behavior of the power amplifier apparatus 300 using a sudden change in RF amplitude A. The response shown in Figure 6 is across a time period of approximately 7 nanoseconds, from t=0 where the amplitude A of the RF input signal is suddenly increased from 0 to 50 mV. As discussed above, there is a sharp, initial increase in $g_{m2}(V_{gsB}^2 + \frac{1}{2}A^2)$ - the third term of the biasing transistor drain current $I_{d\_M3}$ in equation 3. However, this is offset by a gradual drop in $g_m(V_{gsB})$ - the second term of the biasing transistor drain current $I_{d\_M3}$ in equation 3 - due to the decrease in $V_{gsB}$ at biasing transistor M3 caused by the rising bias voltage at the source of M3. Thus, the overall biasing transistor drain current $I_{d\_M3}$ gradually returns back to its initial value $I_{d0}$, after a period of approximately 5 nanoseconds in this example.

The modulation bandwidth of the power amplifier apparatus 300 will be related to how long it takes to reach the new steady state. According to the second term in the equation 3 for $I_{d\_M3}$, the output resistance seen at the source of biasing transistor M3 equals $1/g_m$ for base-band frequencies. Due to the current mirror transistors M4, M5 the overall output resistance $R_{oBB}$ is reduced by a factor of (1+M):

$$R_{oBB} = \frac{1}{(1+M)g_m} \qquad (4)$$

The current mirror may be biased in class A with optimum drain-current density, such that its bandwidth is very high and therefore M can be regarded as frequency independent in this derivation. It is assumed that the parallel-equivalent resistive part of the drive/source-impedance at the RF input $RF_{in}$, which is in parallel with $R_{oBB}$, is much larger than $R_{oBB}$ for base-band frequencies. Drain output resistance and current-source output resistance have been neglected in this derivation.

A total capacitance $C_{tot}$ at the RF input node $RF_{in}$ approximately amounts to:

$$C_{tot} = C_{gs_{M3}} + C_{gs_{M0}} + C_{sBB} \qquad (5)$$

where $C_{sBB}$ represents the parallel-equivalent capacitive part of the drive/source-impedance at the RF input $RF_{in}$ for base-band frequencies. Drain output capacitance and current-source output capacitance has been neglected in the above equation. Therefore, the corresponding RC time constant $\tau$ is

$$\tau = R_{oBB}C_{tot} = \frac{C_{gs_{M3}} + C_{gs_{M0}} + C_{sBB}}{(1+M)g_m} \qquad (6)$$

This time constant corresponds to a bandwidth B (in Hz) of

$$B = \frac{1}{2\pi\tau} = \frac{(1+M)g_m}{2\pi\left(C_{gs_{M3}} + C_{gs_{M0}} + C_{sBB}\right)} \qquad (7)$$

The relationship of equation 7 clearly shows the operating principles of the present disclose. Due to the 1:M current mirror, the bandwidth B can be significantly increased, so that any manifestation of memory effects can be shifted to higher base-band frequencies. Equation 7 also shows that the bandwidth B cannot be simply increased by increasing the $g_m$ of M3 (by increasing its size together with increasing the value of $I_{bias}$), since this would lead to a higher value of $C_{gs\_M3}$ which would be counterproductive according to the same equation. Thus, the rectification booster 330 with a current mirror can improve the performance of power amplifiers, compared to those that use known adaptive bias circuits.

Instead of studying the step response as described above, the power amplifier apparatus 300 could also be subjected to a two-tone test (as discussed above in relation to Figures 4 and 5). Two RF tones with different frequencies $f_1$ and $f_2$ are applied to the RF input $RF_{in}$. The corresponding radian frequencies are $\omega_1 = 2\pi f_1$ and $\omega_2 = 2\pi f_2$, respectively.

Via the aforementioned RF voltage division between $C_{gs\_M3}$ and $C_{C3}$, the two tones reach, after attenuation, the biasing transistor M3 gate-source voltage:

$$V_{gs_{M3}} = V_{gs0} + V_{gsB} + A_{tt}\cos(\omega_1 t) + A_{tt}\cos(\omega_2 t) \qquad (8)$$

From equation 8, it can be seen that the amplitude of each of the two tones has been assumed to be equal to Att.

This expression for the biasing transistor M3 gate-source voltage can be rewritten as:

$$V_{gs_{M3}} = V_{gs0} + V_{gsB} + 2A_{tt} \cos\left(\frac{1}{2}\omega_s t\right)\cos(\omega_c t) \qquad (9)$$

where $\omega_s$ represents the tone spacing, which is the absolute difference between the two frequencies $\omega_1$ and $\omega_2$ ($\omega_s = |\omega_1 - \omega_2|$), and where $\omega_c$ represents the centre/carrier frequency, which is the average of the 2 frequencies $\omega_1$ and $\omega_2$ ($\omega_c = \frac{1}{2}(\omega_1 + \omega_2)$). Comparison of the above equation with the original equation for $V_{gs\_M3}$ (equation 2 above) shows that:

$$A = 2A_{tt} \cos\left(\frac{1}{2}\omega_s t\right) \qquad (10)$$

In other words, the addition of two RF tones at frequencies $\omega_1$ and $\omega_2$ is equivalent to one single RF tone at $\omega_c$, of which the amplitude A is continuously varying in a periodic fashion with a radian frequency $\omega_s/2$. In actual fact, the amplitude is the absolute value of A, denoted as |A|. Due to the $A^2$ term in expression (3) for the biasing transistor drain current $I_{d\_M3}$, the frequency $\omega_s/2$ will be doubled. Thus a frequency component at $2(\omega_s/2) = \omega_s$ will be present in the biasing transistor drain current $I_{d\_M3}$.

So long as this frequency component $\omega_s$ is well within the bandwidth ($2\pi B$) of the circuit, suitable linearization can be achieved. In case the frequency component $\omega_s$ is outside the bandwidth, a memory effect is to be expected. Note that in the above derivation, only the bias signal generated by biasing transistor M3 is taken into account. However, in reality, a second-harmonic RF component generated by biasing transistor M3 may also affect the gain compression/expansion of the first transistor M0. However, this effect is expected to be small; the second-harmonic RF component is strongly suppressed in the voltage domain by the total capacitance Ctot at the RF input RF_in.

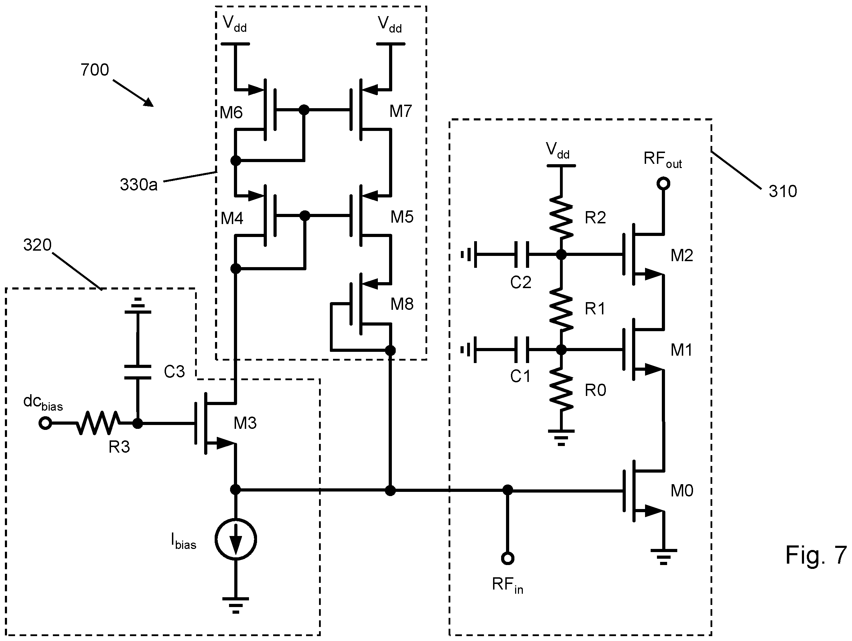

Figure 7 shows another example of a power amplifier apparatus 700 according to the present disclosure. The power amplifier apparatus 700 comprises a power amplifier circuit 310 and adaptive bias circuit 320 (like those described in Figure 3). The power amplifier apparatus 700 further comprises a rectification booster 330a, which is similar to the rectification booster 330 described in Figure 3, but comprises further pairs of transistors - i.e., each side of the current mirror device comprises two or more transistors.

The rectification booster 330a comprises a first pair of transistors M4, M5 as discussed above, and a second pair of transistors M6, M7. The second pair of transistors M6, M7 are stacked relative to the first pair of transistors M4, M5 - the drain of the first transistor M6 of the second pair is coupled to the source of the first transistor M4 of the first pair; the drain of the second transistor M7 of the second pair is coupled to the source of the second transistor M5 of the first pair; and the gates of the second pair M6, M7 are coupled to one another and further coupled to the source of the first transistor M4 of the first pair.

The stacked current mirror of the rectification booster 330a may be used to support higher supply voltages, as the total voltage over the stacked transistors is distributed among a greater number of transistor pairs.

Although M4 and M5 are still referred to as the 'first' pair of transistors (for the sake of consistency), it will be understood that the second pair of transistors M6, M7 will primarily determine the mirror ratio M of the current mirror device. The ratio of W/L aspect ratios of the second pair of transistors M6, M7 may be configured to provide a suitable mirror ratio M. The first pair of transistors M4, M5 will be of secondary importance, primarily being provided to distribute the voltage across the stacked transistors. The ratio of W/L aspect ratios of the first pair of transistors M4, M5 may be the same as for the second pair of transistors M6, M7, or may be 1, for example.

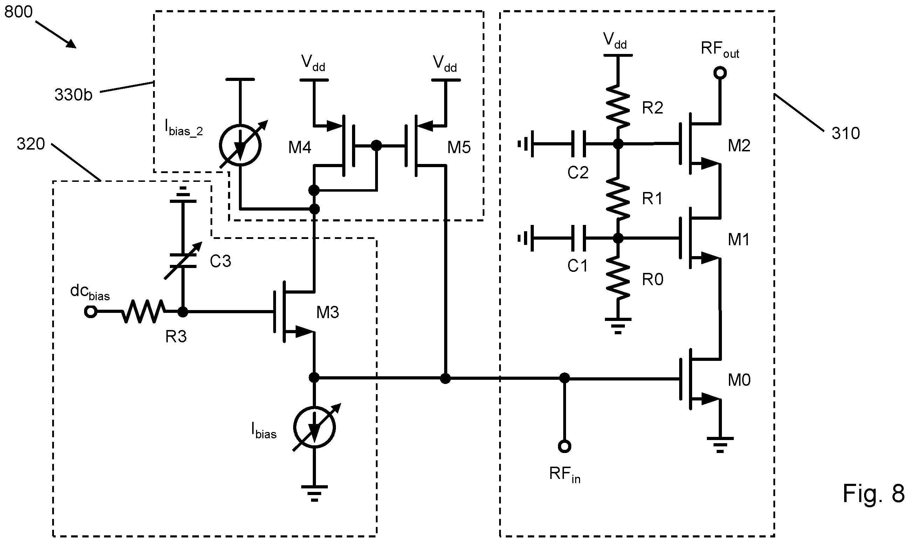

A further transistor M8 may be provided at the output of the second side of the current mirror. The drain of the second transistor M5 of the first pair is coupled to the source of the further transistor M8. The gate and drain of the further transistor M8 are both coupled to the RF input RF_in and power amplifier circuit transistor M0 gate. The further transistor M8 can reduce the gate-to-drain voltage drop across the second transistor M5 of the first pair, which may improve the safe operating area (SOA) of the power amplifier apparatus 700. Although this may be particularly advantageous for the stacked transistor array shown in Figure 7 (which may be used to distribute greater supply voltages), a similar further transistor may be used in any of the examples of the present disclosure (e.g., in the apparatus of Figures 3 or 8). The further transistor M8 may provide for improved balance/symmetry of the voltage distribution over the transistors of the current mirror. This may allow the rectification booster 330a to be more tolerant to variation on $V_{dd}$, for example.

The stacked rectification booster 330a of Figure 7 comprises a first and second pair of transistors M4, M5; M6, M7. However, further transistor pairs may be provided if needed, the further pairs being stacked relative to the second pair M6, M7 in the same manner as described above.

Figure 8 shows a further example of a power amplifier apparatus 800 according to the present disclosure. The power amplifier apparatus 800 comprises a power amplifier circuit 310 and adaptive bias circuit 320 (like those described in Figure 3). The power amplifier apparatus 800 further comprises a rectification booster 330b, which is similar to the rectification booster 330 described in Figure 3, but comprises an additional current source $I_{bias\_2}$. The additional current source $I_{bias\_2}$ may also be provided alongside a stacked rectification booster like that shown in Figure 7.

The additional current source $I_{bias\_2}$ is coupled to the drain of the first transistor M4 of the first pair of transistors and to the drain of the biasing transistor M3. The additional current source $I_{bias\_2}$ reduces the current dissipation of the tail current source $I_{bias}$ and, in turn, the current dissipation of the adaptive bias circuit 320.

Assuming the first pair of transistors M4, M5 have a current mirroring ratio of 1:M, without the additional current source $I_{bias\_2}$, the second transistor M5 has M times the bias current of the biasing transistor M3 ($I_{bias\_M5} = M^*I_{bias\_M3}$), and thus the tail current source $I_{bias} = I_{bias\_M5} + I_{bias\_M3} = (1+M)^*I_{bias\_M3}$. By contrast, where the additional current source $I_{bias\_2}$ is provided, the second transistor M5 has a bias current of $I_{bias\_M5} = M^*(I_{bias\_M3} - I_{bias\_2})$, and thus the tail current source $I_{bias} = I_{bias\_M5} + I_{bias\_M3} = (1+M)^*I_{bias\_M3} - M^*I_{bias\_2}$. Therefore, the additional current source reduces current dissipation across the whole of the adaptive bias circuit 320 by $M^*I_{bias\_2}$.

The tail current source $I_{bias}$, additional current source $I_{bias\_2}$ and/or the capacitor C3 may be adjustable or reconfigurable (i.e., the currents provided at $I_{bias}$ and $I_{bias\_2}$, and the capacitance of C3, may be varied). These components are depicted as reconfigurable components in the power amplifier apparatus 800 of Figure 8. Such reconfigurable components could be used in any of the other examples disclosed herein. Any suitable means can be used to provide this reconfigurability. The current sources may comprise a current digital-to-analogue (current-DAC), for example. The capacitor C3 may comprise a varactor or a switch-capacitor array, for example. By reconfiguring any or all of these components, the operation of the power amplifier apparatus 800 may be made more robust. The performance limits of the apparatus may be extended and/or these components may be varied so as to ensure that acceptable performance is achieved over a greater range of operating conditions. For example, the current and/or capacitance may be varied so as to compensate for a change caused by variations in operating temperature.

From reading the present disclosure, other variations and modifications will be apparent to the skilled person. Such variations and modifications may involve equivalent and other features which are already known in the art of power amplifiers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A power amplifier apparatus (300, 700, 800) comprising:

   a power amplifier circuit (310) configured to receive an RF input signal at an RF input ($RF_{in}$) and to generate an RF output signal at an RF output ($RF_{out}$);
   an adaptive bias circuit (320) comprising a biasing transistor (M3), the biasing transistor (M3) having a common terminal coupled to the RF input ($RF_{in}$) and to a tail current source ($I_{bias}$), the biasing transistor (M3) further having an input terminal coupled to a DC bias voltage source ($dc_{bias}$); and
   a rectification booster (330) comprising a current mirror device, wherein a first side of the current mirror device is coupled to an output terminal of the biasing transistor (M3) and a second side of the current mirror device is coupled to the RF input ($RF_{in}$).

2. The power amplifier apparatus (300, 700, 800) of claim 1, wherein the current mirror device comprises a first pair of transistors (M4, M5), wherein:

   each transistor of the first pair of transistors (M4, M5) comprises an input terminal coupled to one another;
   a first transistor (M4) of the first pair of transistors comprises an output terminal coupled to the output terminal of the biasing transistor (M3);

a second transistor (M5) of the first pair of the transistors comprises an output terminal coupled to the RF input (RF$_{in}$); and

the input terminals of each transistor of the first pair of transistors (M4, M5) are coupled to the output terminal of the first transistor (M4) of the first pair of transistors.

3.  The power amplifier apparatus (700) of claim 2, wherein the current mirror device comprises a second pair of transistors (M6, M7), wherein:

each transistor of the second pair of transistors (M6, M7) comprises an input terminal coupled to one another; the input terminals of each transistor of the second pair of transistors (M6, M7) are coupled to the output terminal of the first transistor (M6) of the second pair of transistors; and the first and second pair of transistors (M6, M7) are stacked with respect to the first pair of transistors, such that an output terminal of the first transistor (M6) of the second pair of transistors is coupled to a common terminal of the first transistor (M4) of the first pair of transistors and an output terminal of the second transistor (M7) of the second pair of transistors is coupled to a common terminal of the second transistor (M5) of the first pair of transistors.

4.  The power amplifier apparatus (700) of claim 3, wherein the current mirror device comprises further pairs of transistors, the further pairs of transistors being stacked with respect to the second pair of transistors (M6, M7).

5.  The power amplifier apparatus (700) of any of claims 2 to 4, wherein a further transistor (M8) is coupled to the first pair of transistors (M4, M5), the further transistor (M8) having a common terminal coupled to the output terminal of the second transistor (M5) of the first pair of transistors, and the further transistor (M8) further having an output terminal and an input terminal coupled to the RF input (RF$_{in}$).

6.  The power amplifier apparatus (300, 700) of any of claims 2 to 5, wherein a width-to-length aspect ratio of a second transistor of a main pair of transistors of the current mirror device is unequal to a width-to-length aspect ratio of a first transistor of the main pair of transistors.

7.  The power amplifier apparatus (300, 700, 800) of any preceding claim, wherein the first side and the second side of the current mirror device are coupled to a common supply voltage line (V$_{dd}$).

8.  The power amplifier apparatus (800) of any preceding claim, wherein the rectification booster (330b) further comprises an additional current source (I$_{bias\_2}$) coupled to the output terminal of the biasing transistor (M3).

9.  The power amplifier apparatus (300, 700, 800) of any preceding claim, wherein the input terminal of the biasing transistor (M3) is coupled to a common voltage line via a capacitor (C3) and to the DC bias voltage source (dc$_{bias}$) via a resistor (R3).

10.  The power amplifier apparatus (300, 700, 800) of any preceding claim, wherein the power amplifier circuit (310) comprises a first transistor (M0) having an input terminal coupled to the RF input (RF$_{in}$) and the common terminal of the biasing transistor (M3).

11.  The power amplifier apparatus (300, 700, 800) of claim 10, wherein the power amplifier circuit (310) comprises a plurality of transistors, the plurality of transistors comprising one or more further transistors (M1, M2) in a cascode arrangement with the first transistor (M0).

12.  The power amplifier apparatus (300, 700, 800) of claim 11, wherein the power amplifier circuit (310) comprises a second transistor (M1) and a third transistor (M2), wherein an output terminal of the first transistor (M0) is coupled to a common terminal of the second transistor (M1), an output terminal of the second transistor (M1) is coupled to a common terminal of the third transistor (M2), and an output terminal of the third transistor (M2) is coupled to the RF output (RF$_{out}$).

13.  The power amplifier apparatus (300, 700, 800) of claim 12, wherein the second transistor (M1) comprises an input terminal coupled to a capacitor (C1), and wherein the third transistor (M2) comprises an input terminal coupled to another capacitor (C2).

14.  The power amplifier apparatus (300, 700, 800) of any preceding claim, wherein each of the transistors is a Complementary Metal-Oxide-Semiconductor, CMOS, transistor.

**15.** The power amplifier apparatus (300, 700, 800) of any preceding claim, wherein the power amplifier circuit (310) further comprises an input impedance matching circuit configured to receive the RF input signal and an output impedance matching circuit configured to receive the RF output signal.

Fig. 1

EP 4 734 362 A1

Fig. 2

Fig. 3

Fig. 4

EP 4 734 362 A1

Fig. 5

Fig. 6

Fig. 7

Fig. 8

## EUROPEAN SEARCH REPORT

**Application Number**

EP 24 20 8604

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/036340 A1 (YOSHIMASU TOSHIHIKO [JP] ET AL) 30 January 2020 (2020-01-30) | 1,2,5-15 | INV. |
| A | * paragraphs [0002] - [0131]; figures 1-9 * | 3,4 | H03F1/02 |
| | ----- | | H03F1/22 |
| | | | H03F1/30 |
| A | KENNEY J G ET AL: "AN ENHANCED SLEW RATE SOURCE FOLLOWER", IEEE JOURNAL OF SOLID-STATE CIRCUITS, IEEE, USA, vol. 30, no. 2, 1 February 1995 (1995-02-01), pages 144-146, XP000496306, ISSN: 0018-9200, DOI: 10.1109/4.341742 * page 144, left-hand column, line 15 - page 146, right-hand column, line 27; figures 1-4 * | 1-15 | H03F3/195 H03F1/32 |
| | ----- | | |
| A | US 2011/043284 A1 (ZHAO YU [US] ET AL) 24 February 2011 (2011-02-24) * paragraphs [0005] - [0059]; figures 1-8 * | 1-15 | |
| | ----- | | **TECHNICAL FIELDS SEARCHED (IPC)** |
| | | | H03F |
| | | | G05F |

The present search report has been drawn up for all claims

| Place of search | Date of completion of the search | Examiner |
|---|---|---|
| The Hague | 18 March 2025 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 8604

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2025

| Patent document cited in search report | Publication date | Patent family member(s) | | Publication date |
|---|---|---|---|---|
| US 2020036340 A1 | 30-01-2020 | NONE | | |
| US 2011043284 A1 | 24-02-2011 | CN | 102484452 A | 30-05-2012 |
| | | EP | 2467935 A1 | 27-06-2012 |
| | | JP | 5420768 B2 | 19-02-2014 |
| | | JP | 2013502847 A | 24-01-2013 |
| | | KR | 20120061894 A | 13-06-2012 |
| | | US | 2011043284 A1 | 24-02-2011 |
| | | WO | 2011022551 A1 | 24-02-2011 |

EPO FORM P0459

For more details about this annex : see Official Journal of the European Patent Office, No. 12/82